# DEMANDE DE BREVET EUROPEEN

(11) **EP 3 660 749 A1**
(43) Date de publication de la demande: **03.06.2020**
(21) Numéro de dépôt: 19211607.7
(22) Date de dépôt: 26.11.2019
(51) Int. Cl.: G06N 3/063, G06N 3/04, G06N 3/08

(54) **CIRCUIT NEURONAL APTE À METTRE EN OEUVRE UN APPRENTISSAGE SYNAPTIQUE**

(30) Priorité: 27.11.2018 FR 1871944
(71) Demandeur: Commissariat à l'énergie atomique et aux énergies alternatives, 75015 Paris (FR)
(72) Inventeur: RUMMENS, François, 38054 Grenoble Cedex 09 (FR); VALENTIAN, Alexandre, 38054 Grenoble Cedex 09 (FR)
(74) Mandataire: Brevalex

(57) **Abrégé**

L'invention porte sur un circuit d'intégration synaptique (30) pour puce neuromorphique comprenant une synapse à mémoire résistive (S1-S3) qui dispose d'une borne d'activation (B_{A}) pour recevoir un signal d'action présynaptique (Sa3) et d'une borne de propagation (B_{P}) destinée à être reliée audit circuit pour transmettre un signal de sortie synaptique qui dépend de la résistance de ladite mémoire.

Le circuit comprend un accumulateur (Cm) du signal de sortie synaptique, un comparateur (Comp) configuré pour émettre une impulsion postsynaptique (So) en cas de franchissement d'un seuil (Vm) par le signal de sortie accumulé. Il comprend en outre une unité de contrôle configurée, lorsqu'un signal d'action présynaptique est appliqué sur la borne d'activation, pour imposer une tension de modification de conductance à la synapse en venant commander l'application d'un signal d'action postsynaptique (*V_{BLₛₑₜ}, V_{BLᵣₑₛₑₜ}*) sur la borne de propagation.

## Description

### DOMAINE TECHNIQUE

Le domaine de l'invention est celui des puces neuromorphiques à réseaux de neurones artificiels exploitant des synapses à mémoire résistive. L'invention concerne plus particulièrement l'apprentissage effectué directement sur puce d'un tel réseau de neurones.

### ÉTAT DE LA TECHNIQUE ANTÉRIEURE

Une cellule nerveuse, ou neurone, peut être décomposée en plusieurs parties :
- Les dendrites qui sont les entrées du neurone via lesquelles il reçoit des signaux d'excitation ou d'inhibition ;
- Le corps du neurone qui est le théâtre d'échanges ioniques à travers la membrane cellulaire ;
- L'axone, une longue extension du corps cellulaire, qui est l'unique sortie du corps.

Selon les signaux d'excitation ou d'inhibition reçus au niveau des dendrites, des ions transitent à travers la membrane cellulaire. Le déséquilibre de charges entre l'intérieur et l'extérieur de la cellule induit une différence de tension de part et d'autre de la membrane. On parle alors de tension de membrane aux bornes d'une capacité de membrane. Lorsque cette tension de membrane dépasse un certain niveau, c'est-à-dire lorsque la cellule est suffisamment excitée, le neurone connait un échange brutal d'ions. Il en résulte une variation significative de la tension de membrane. Cette variation, appelée potentiel d'action (« action potential » ou encore « spike » en anglais), se propage le long de l'axone, vers les boutons synaptiques qui constituent les sorties du neurone. Vus de l'extérieur de la cellule, ces « spikes » constituent l'activité électrique du neurone.

Dans un réseau de neurones biologiques, chaque neurone est connecté à plusieurs milliers d'autres via autant de synapses. Le terme synapse désigne la connexion entre la terminaison axonique d'un neurone dit présynaptique et une dendrite d'un neurone dit postsynaptique. L'influence du neurone présynaptique sur le neurone postsynaptique est pondérée par le poids de la synapse qui peut être excitatrice ou inhibitrice. Dans le premier cas, un « spike » présynaptique charge la tension de membrane du neurone postsynaptique et précipite la génération d'un potentiel d'action postsynaptique. Dans le second cas, un « spike » présynaptique a pour effet de dépolariser la membrane postsynaptique et de retarder l'apparition d'un potentiel d'action postsynaptique.

Les réseaux de neurones artificiels sont utilisés dans différents domaines de traitement du signal (visuel, sonore ou autre) comme par exemple dans le domaine de la classification de données, de la reconnaissance d'images ou de la prise de décision. Ils sont inspirés des réseaux de neurones biologiques dont ils imitent le fonctionnement et sont essentiellement composés de neurones artificiels interconnectés entre eux par des synapses, qui sont classiquement implémentées par des mémoires numériques, mais qui peuvent être également implémentées par des composants résistifs dont la conductance varie en fonction de la tension appliquée à leurs bornes.

Avant d'être fonctionnel, un tel réseau de neurone doit passer par une phase d'apprentissage qui consiste à ajuster les poids des synapses en fonction des entrées du réseau pour que le réseau y associe les sorties souhaitées. Une stratégie d'apprentissage possible est une stratégie effectuée par le réseau lui-même (on parle d'apprentissage « on-chip ») et réalisée de manière non supervisée en ce sens que les entrées envoyées au réseau ne sont pas étiquetées, le réseau déterminant de lui-même à quelle classe appartient quelle entrée pour venir associer à chaque classe un neurone de la couche de sortie.

Une implémentation classique de l'apprentissage non-supervisé repose sur des neurones impulsionnels (également dénommé neurone à potentiel d'action ou « spiking neuron » en anglais). Le modèle le plus simple de neurone impulsionnel est du type intégratif à seuil (« Integrate and Fire » en anglais) : il intègre ses entrées, compare le résultat de cette intégration à un seuil et émet une impulsion (un « spike ») lors du franchissement de ce seuil tout en déchargeant la tension de membrane.

Une loi d'apprentissage possible est une loi dite de plasticité dépendante du temps d'occurrence des impulsions (loi STPD pour « Spike Timing Dépendent Plasticity ») selon laquelle chaque synapse régule son poids en fonction des occurrences relatives entre les impulsions pré et postsynaptiques. Si une impulsion présynaptique est suivie d'une impulsion postsynaptique, la loi suppose un lien de causalité à conserver et renforce la synapse en augmentant son poids. Au contraire, si une impulsion postsynaptique apparait peu de temps avant une post présynaptique, le poids synaptique doit être diminué. Dans les deux cas, plus le temps entre les impulsions pré et post-synaptiques est bref, plus grande est l'importance de la modification du poids.

Une autre loi d'apprentissage possible est celle dite de plasticité synaptique pilotée par les impulsions (loi SDSP pour « Spike-Driven Synaptic Plasticity ») qui présente l'intérêt de ne pas avoir à surveiller un écart temporel par synapse comme c'est le cas pour la loi STDP. Selon la loi SDSP, à chaque impulsion présynaptique reçue, chaque synapse vient sonder l'état du neurone postsynaptique et adapter son poids en conséquence. Si la tension de membrane de ce neurone postsynaptique est proche du seuil, on en déduit que l'impulsion présynaptique a de bonnes chances de déclencher l'émission d'un potentiel d'action et donc que le neurone présynaptique qui a émis cette impulsion a un effet important sur le neurone postsynaptique. On vient alors renforcer la liaison synaptique en augmentant le poids de la synapse (on parle de potentialisation à long terme ou LTP pour « Long Term Potentiation »). Dans le cas contraire, c'est-à-dire si la tension de membrane postsynaptique est proche de zéro, le poids est diminué (dépression à long terme ou LTD pour « long Term Depression »).

Afin d'éviter que les poids synaptiques ne soient modifiés à chaque impulsion présynaptique, une seconde règle limite l'apprentissage. L'activité moyenne de chaque neurone est estimée grâce à une variable, la concentration en ions calcium. Cette concentration augmente lorsque le neurone émet une impulsion et diminue sinon. La potentialisation ou la dépression d'une synapse est alors réalisée ou non selon le niveau de calcium de son neurone postsynaptique.

Enfin, les synapses utilisées pour l'apprentissage SDSP sont des synapses bistables qui peuvent prendre plusieurs valeurs, mais dont seulement deux de ses valeurs sont stables, *P_{MIN}* et *P_{MAX}.* Cette instabilité se traduit par le comportement suivant. Tout poids synaptique inférieur à une valeur *Pₘ* située entre *P_{MIN}* et *P_{MAX}* voit son poids diminuer doucement vers *P_{MIN}* et, inversement, tout poids synaptique supérieur à *Pₘ* subit une potentialisation graduelle. En fin d'apprentissage, tous les poids synaptiques valent donc soit *P_{MIN}* soit *P_{MAX}.*

De par leur grande densité et leur caractère non-volatil, les memristors ou RRAM sont des candidats idéaux à l'implémentation de synapses. La résistance variable de ces dispositifs peut être augmentée (opération dite *Reset*) ou diminuée (opération *Set*) si on y applique des grandeurs électriques (tension et/ou courant) relativement élevées. Si on veut simplement lire la valeur de leur résistance sans la modifier (opération *Read*), il faut appliquer des grandeurs électriques relativement faibles.

L'intégration de synapses résistives prend souvent la forme d'un plan mémoire, qu'on nomme « plan synaptique », dans lequel les synapses sont agencées en un réseau à lignes et colonnes transversales. Chaque synapse dispose d'une borne d'activation de la synapse et d'une borne de propagation du signal synaptique. Les bornes d'activation des synapses d'une même ligne sont reliées entre elles par l'intermédiaire d'une ligne de mot (ou « Word-Line »), et les bornes de propagation des synapses d'une même colonne sont reliées entre elles et connectées à un circuit d'intégration synaptique (un neurone artificiel du type intégratif à seuil) par l'intermédiaire d'une ligne de bit (ou « Bit-Line »). Une ligne de mot est utilisée pour injecter une impulsion en tension dans les synapses de la ligne correspondante et les lignes de bit sont les sorties de ces synapses. En présence d'une activation présynaptique sur une ligne de mot, chaque ligne de bit propage un courant pondéré par la valeur de la mémoire résistive correspondante.

Un tel plan synaptique permet ainsi de relier une couche de neurones d'entrée (les neurones présynaptiques) et une couche de neurones de sortie (les neurones postsynaptiques). Un neurone d'entrée stimule une ligne de synapses lors de l'émission d'une impulsion présynaptique via une ligne de mot, et chacun des neurones de sortie intègre la stimulation synaptique pondérée par la valeur de la mémoire résistive auquel il est relié via une ligne de bit.

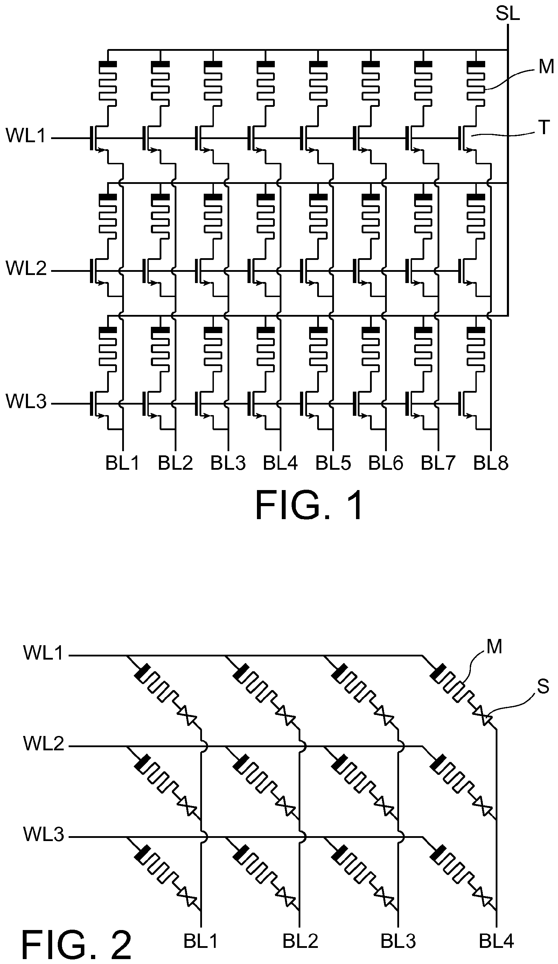

Comme représenté en figure 1, une synapse à mémoire résistive prend généralement la forme d'une cellule 1T1R composée d'une résistance variable M et d'un transistor d'accès T servant à réguler les courants d'écriture et dont la grille forme la borne d'activation de la synapse. On a représenté sur la figure 1 un exemple d'un plan synaptique à cellules 1T1R comprenant trois lignes de mot WL1-WL3, huit lignes de bit BL1-BL8 chacune destinée à être reliée à un neurone de sortie et une ligne de source (ou « Source-Line ») SL reliée à toutes les synapses. La présence d'un transistor par synapse limite la densité d'un tel plan synaptique.

Comme représenté en figure 2, on peut alternativement avoir recours à des cellules 1S1R composée d'une résistance variable M et d'un sélecteur S ayant un comportement similaire à une diode, voire à deux diodes en tête-bêche. Chaque cellule 1S1R est un dipôle dont les bornes constituent les bornes d'activation et de propagation, et le plan synaptique s'organise comme représenté en figure 2 où l'on a pris l'exemple d'un plan comprenant trois lignes de mots WL1-WL3 et de quatre lignes de bits BL1-BL4, et où chaque synapse est prise entre une tension sur la ligne de mot correspondante et une tension sur sa ligne de bit correspondante.

On connait du document WO 2016/067139 A1 une solution pour réaliser un apprentissage de type STDP. Cette solution nécessite néanmoins de densifier la structure de chacune des synapses à mémoire résistive et vient complexifier le plan synaptique en requérant que chaque neurone postsynaptique soit reliée aux synapses d'une colonne non seulement par une ligne de bit reliée aux bornes de propagation des synapses mais également par une ligne de bit supplémentaire reliée à une troisième borne d'accès des synapses en supplément des bornes d'activation et de propagation.

### EXPOSÉ DE L'INVENTION

L'invention a pour objectif de proposer une solution moins complexe pour réaliser l'apprentissage des synapses reliant deux couches successives de neurones. Elle propose pour cela un circuit d'intégration synaptique pour puce neuromorphique comprenant une synapse à mémoire résistive qui dispose d'une borne d'activation pour recevoir un signal d'action présynaptique et d'une borne de propagation destinée à être reliée audit circuit pour transmettre un signal de sortie synaptique qui dépend de la résistance de ladite mémoire. Le circuit comprend un accumulateur du signal de sortie synaptique, un comparateur configuré pour émettre une impulsion postsynaptique en cas de franchissement d'un seuil par le signal de sortie accumulé. Ce circuit comprend en outre une unité de contrôle configurée, lorsqu'un signal d'action présynaptique est appliqué sur la borne d'activation, pour imposer une tension de modification de conductance à la synapse en venant commander l'application d'un signal d'action postsynaptique sur la borne de propagation.

Certains aspects préférés mais non limitatifs de ce circuit sont les suivants :
il comprend un connecteur commutable configuré pour connecter l'accumulateur à la borne de propagation lorsqu'une impulsion de lecture du signal d'action présynaptique est appliquée sur la borne d'activation ;
le connecteur commutable est configuré pour déconnecter l'accumulateur de la borne de propagation lorsqu'une impulsion d'écriture du signal d'action présynaptique est appliquée sur la borne d'activation ;
l'unité de contrôle est en outre configurée, lorsque l'impulsion de lecture du signal d'action présynaptique est appliquée sur la borne d'activation, pour imposer une tension de lecture à la synapse en venant commander l'application d'un signal de lecture postsynaptique sur la borne de propagation ;
il comprend un amplificateur opérationnel monté en suiveur pour générer le signal de lecture postsynaptique appliqué à la borne de propagation ;
l'unité de contrôle est en outre configurée, lorsque le signal d'action présynaptique est appliqué sur la borne d'activation, pour imposer une tension de lecture à la synapse en venant commander l'application d'un signal de lecture postsynaptique sur la borne de propagation ;
il comprend un amplificateur opérationnel monté en suiveur qui est utilisé pour générer sélectivement le signal de lecture postsynaptique ou le signal d'action postsynaptique ;
il comprend un dispositif abaisseur de courant qui est interposé entre la borne de propagation et l'accumulateur et qui est activé lorsque le circuit impose une tension de modification de conductance à la synapse ;
l'unité de contrôle est configurée pour commander l'application du signal d'action postsynaptique sur la borne de propagation conformément à une logique d'apprentissage de type plasticité synaptique pilotée par les impulsions ;
le signal d'action postsynaptique est l'un d'un signal de potentialisation et d'un signal de dépression.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels, outre les figures 1 et 2 déjà discutées précédemment,
- les figures 3 et 4 illustrent la régulation de la tension de bus réalisée par des circuits conformes à l'invention à des fins de lecture ou d'écriture d'une mémoire résistive ;
- les figures 5 à 8 sont des schémas représentant différents exemples de réalisation d'un circuit selon l'invention.

### EXPOSÉ DÉTAILLÉ DE MODES DE RÉALISATION PARTICULIERS

L'invention a pour cadre un plan synaptique tel que décrit précédemment où les impulsions présynaptiques sont injectées les unes après les autres sur leur ligne de mot correspondante. À chaque impulsion présynaptique d'un neurone de la couche d'entrée, toute une ligne de synapses est activée et tous les neurones de la couche de sortie sont stimulés via leur ligne de bit correspondante suivant le poids de la synapse qui leur correspond et qui correspond à la ligne de mot activée.

Au cours de l'apprentissage préférentiellement mais non exclusivement de type SDSP, le poids de chaque synapse peut-être mis à jour. Avec un apprentissage de type SDSP, une telle mise à jour (i.e. une potentialisation ou une dépression) se produit ou pas selon le seul état du neurone post-synaptique (sa tension de membrane et son niveau de calcium).

Dans le cadre de l'invention, les synapses sont des synapses à mémoire résistive de type 1T1R ou 1S1R. Dans une implémentation possible, les mémoires des synapses sont des mémoires RRAM unipolaires, multivaluées et à écriture cumulative. Cela signifie que les tensions et courants nécessaires aux différentes actions (*Set, Reset, Read*) sont appliqués avec la même polarité, que la résistance des mémoires peut prendre toute une gamme de valeurs et que des écritures successives de même type (*Set* ou *Reset*) décalent progressivement la résistance de la mémoire dans la direction souhaitée. Un exemple d'une telle mémoire est la mémoire à changement de phase (PCM pour « Phase Change Memory). On relèvera que la mémoire PCM est soumise à un effet de dérive tel qu'une mémoire ayant une valeur de résistance importante voit celle-ci augmenter et que, dans une moindre mesure, une mémoire ayant une faible valeur de résistance voit celle-ci diminuer.

L'invention n'est toutefois pas limitée à de telles mémoires, et s'étend ainsi à des synapses qui n'exploitent pas de mémoire multivaluée mais sont constituée de plusieurs mémoires binaires en parallèle. Les accès en écriture (*Set, Reset*) à la synapse imposent dans ce cas une tension aux mémoires constituant la synapse telle que certaines mémoires changent d'état et pas d'autres. L'invention s'étend également à des synapses exploitant des mémoires bipolaires et dans un tel cas de figure on prévoit une tension sur la ligne de source (ou sur une ligne de mot dans le cas de cellules 1S1R) en milieu de gamme de tension et des tensions sur les lignes de bit pouvant être supérieures ou inférieures à la tension précitée.

On prend dans ce qui suit l'exemple de mémoires PCM pour lesquelles une tension *V_{read}* permet de réaliser une lecture sans modification de la résistance, une tension *Vₛₑₜ* permet de diminuer la valeur de la résistance et une tension *Vᵣₑₛₑₜ* permet de diminuer la valeur de la résistance. À titre d'exemple, on peut prévoir une tension d'alimentation *V_{DD}* = 1,8 *V,* et les tensions d'accès suivantes à une mémoire résistive : *Vₛₑₜ* = 1,6 *V, Vᵣₑₛₑₜ* = 1,2 *V* et *V_{read}* = 0,4 *V.*

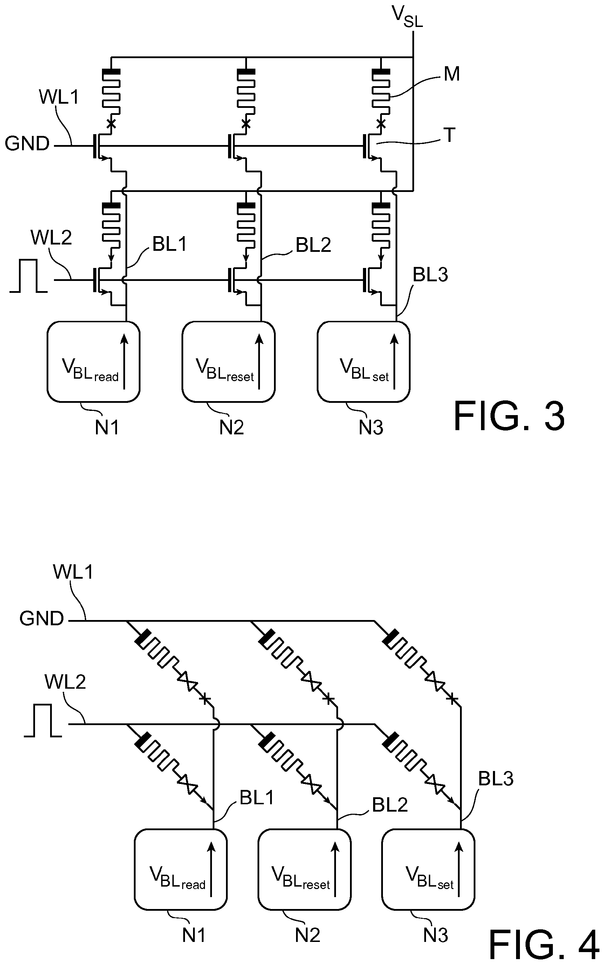

Avec le plan synaptique décrit précédemment, la borne de propagation de chaque synapse est connectée à son neurone post-synaptique via une ligne de bit. Ainsi, pendant le traitement d'une impulsion présynaptique, la synapse est prise entre une tension commune à toutes les synapses de la ligne (la tension de la ligne de source dans le cas d'une cellule 1T1R, la tension de la ligne de mot pour une cellule 1S1R) et une tension propre à sa colonne, donc à son neurone post-synaptique. Prenant l'exemple des figures 3 et 4 où la ligne de mot WL2 est activée, la synapse de la colonne i présente à ses bornes une différence de potentiel égale à *V_{SL} - V_{BLᵢ}* dans le cas d'une cellule 1T1R (figure 3) et égale à *V*_{*WL*2} - *V_{BLᵢ}* dans le cas d'une cellule 1S1R (figure 4). L'invention propose qu'à chaque impulsion présynaptique, chaque neurone de sortie N1-N3 impose sur sa ligne de bit BL1-BL3 une tension qui permet de pratiquer un *Set,* un *Reset* ou un *Read.* On a représenté sur les figures 3 et 4 un exemple dans lequel :
- le neurone N1 impose sur la ligne de bit BL1 une tension *V_{BL_{read}}* telle que *V_{SL}* - *V_{BL_{read}} = V_{read}* (figure 3) ou *V*_{*WL*2} - *V_{BL_{read}} = V_{read}* (figure 4) afin d'effectuer un *Read ;*
- le neurone N2 impose sur la ligne de bit BL2 une tension *V_{BLᵣₑₛₑₜ}* telle que *V_{SL}* - *V_{BLᵣₑₛₑₜ} = Vᵣₑₛₑₜ* (figure 3) ou *V_{WL2}* - *V_{BLᵣₑₛₑₜ} = Vᵣₑₛₑₜ* (figure 4) afin d'effectuer un *Reset ;* et
- le neurone N3 impose sur la ligne de bit BL3 une tension *V_{BLₛₑₜ}* telle que *V_{SL}* - *V_{BLₛₑₜ} = Vₛₑₜ* (figure 3) ou *V*_{*WL*2} - *V_{BLₛₑₜ} = Vₛₑₜ* (figure 4) afin d'effectuer un *Set.*

L'invention permet ainsi d'effectuer l'apprentissage en continu de l'intégration des poids synaptiques et cela dans un même temps pour toutes les synapses de la ligne activée. Cet apprentissage est en outre appliqué au niveau du plan synaptique en étant géré localement par les neurones et non par les synapses qui sont bien plus nombreuses.

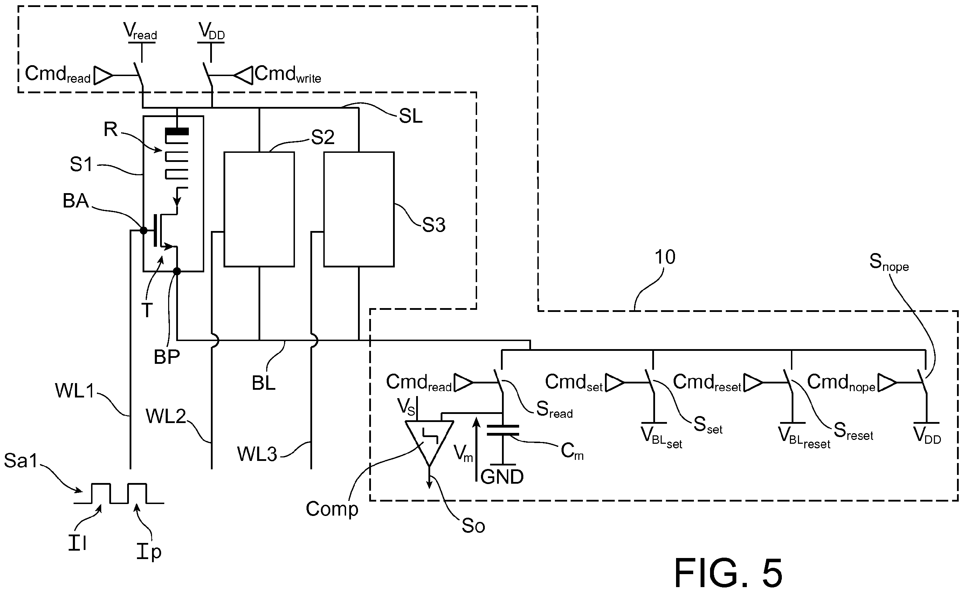

En référence aux figures 5 à 8, l'invention porte plus particulièrement sur un neurone artificiel prenant la forme d'un circuit d'intégration synaptique 10, 20, 30, 40 pour puce neuromorphique. La puce comprend une synapse à mémoire résistive S1, S2, S3 qui dispose d'une borne d'activation B_{A} pour recevoir un signal d'action présynaptique Sa1, Sa2, Sa3, Sa4 et d'une borne de propagation B_{P} destinée à être reliée audit circuit pour transmettre un signal de sortie synaptique qui dépend de la résistance de ladite mémoire.

Sur les figures 5 à 8, on a représenté trois synapses S1, S2 et S3 appartenant à trois lignes d'un plan synaptique et dont la borne d'activation B_{A} est respectivement reliée à une ligne de mot WL1, WL2 et WL3. Ces synapses appartiennent à une même colonne, et leurs bornes de propagation B_{P} sont reliées au circuit d'intégration synaptique 10, 20, 30, 40 via une ligne de bit BL. Sur ces figures, un signal d'action présynaptique Sa1, Sa2, Sa3, Sa4 est appliquée sur la ligne de mot WL1 suite à l'émission d'une impulsion présynaptique par un neurone d'entrée associé à cette ligne de mot, venant activer la synapse S1. Sur ces figures, GND désigne la masse et V_{DD} la tension d'alimentation.

Sur les figures 5, 7 et 8, les synapses sont des cellules 1T1R. La borne d'activation B_{A} d'une synapse est reliée à la grille du transistor T et sa borne de propagation B_{P} est reliée à la source du transistor. La résistance M est prise entre une ligne de signal SL et le drain du transistor T. La ligne de signal SL peut être commune à toutes les synapses du plan ou n'être associée qu'aux synapses d'une ou plusieurs lignes du plan, celui-ci comportant donc plusieurs lignes de signal. Sur la figure 5, la ligne de signal est commune aux trois lignes représentées.

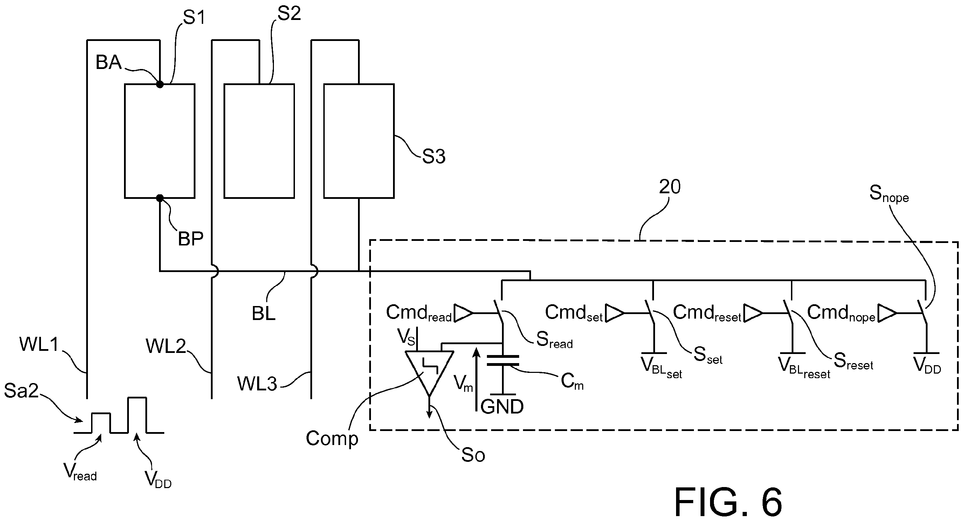

Sur la figure 6, les synapses sont des cellules 1S1R qui disposent chacune de deux pôles formant les bornes d'activation et de propagation de la synapse.

Le circuit d'intégration synaptique 10, 20, 30, 40 comprend un accumulateur Cm du signal de sortie synaptique et un comparateur Comp configuré pour émettre une impulsion postsynaptique So en cas de franchissement d'un seuil Vs par le signal de sortie accumulé Vm qui représente la tension de membrane du neurone. L'accumulateur Cm est symbolisé dans les figures par une simple capacité, mais il peut prendre une forme plus complexe.

Le circuit selon l'invention est en outre configuré, lorsqu'un signal d'action présynaptique est appliqué sur la borne d'activation B_{A} de la synapse S1, pour imposer une tension de modification de conductance à la synapse S1 en venant appliquer un signal d'action postsynaptique sur la borne de propagation B_{P} de la synapse S1 via la ligne de bit BL. Le signal d'action postsynaptique peut être l'un d'un signal de potentialisation et d'un signal de dépression, le circuit étant configuré pour réguler la tension sur la ligne de bit à :
- une tension *V_{BLᵣₑₛₑₜ}* à même d'imposer à la synapse S1 une tension de diminution de conductance *Vᵣₑₛₑₜ* ; ou
- une tension *V_{BLₛₑₜ}* à même d'imposer à la synapse S1 une tension d'augmentation de conductance *Vₛₑₜ.*

Le circuit selon l'invention dispose d'une unité de contrôle (non représentée) configurée pour commander l'application du signal d'action postsynaptique sur la borne de propagation conformément à une logique d'apprentissage. Selon cette logique, l'unité de contrôle peut également être configurée, lorsqu'un signal d'action présynaptique est appliqué sur la borne d'activation B_{A} de la synapse S1, pour imposer sur la borne de propagation B_{P} de la synapse S1 via la ligne de bit BL un signal neutre n'induisant pas de modification de conductance de la synapse. La logique d'apprentissage peut être du type STDP, de sorte que le signal d'action postsynaptique est ou non appliqué selon les occurrences relatives de l'impulsion présynaptique et d'une impulsion postsynaptique. La logique d'apprentissage est de préférence de type SDSP, l'unité de contrôle venant alors uniquement évaluer l'état du neurone, et plus particulièrement sa tension de membrane Vm (laquelle est déjà évaluée pour déterminer si le neurone doit ou non émettre une impulsion) et sa concentration en ions calcium (laquelle peut être évaluée via un simple comptage du nombre d'impulsions émises), pour décider de modifier ou non la conductance de la synapse.

On a vu précédemment que le signal d'action présynaptique Sa1, Sa2, Sa3, Sa4 est appliquée sur la ligne de mot WL1 suite à l'émission d'une impulsion présynaptique par le neurone d'entrée associé à cette ligne de mot.

Dans un premier mode de réalisation représenté sur les figures 5, 6 et 7, on impose sur la ligne de mot WL1, suite à l'émission de l'impulsion présynaptique, un signal d'action présynaptique Sa1, Sa2, Sa3 qui présente deux impulsions successives, dénommées respectivement impulsion de lecture et impulsion d'écriture du signal d'action présynaptique, et qui vont permettre d'assurer respectivement une opération de lecture *Read* (intégration de l'impulsion présynaptique) et une opération d'écriture *Set* ou *Reset* (modification de la conductance). L'impulsion de lecture peut précéder l'impulsion d'écriture, de sorte que l'état du neurone est affecté par la lecture et la décision d'écrire ou pas est prise en fonction de ce nouvel état pour un apprentissage SDSP. Alternativement, l'impulsion d'écriture peut précéder l'impulsion de lecture, auquel cas la contribution de l'impulsion présynaptique utilisera lors de la lecture le poids rafraichi par cette même impulsion lors de l'écriture. Dans une variante de réalisation, l'état du neurone postsynaptique est sondé en premier lieu et la décision de modifier ou non la conductance est sauvegardée dans une mémoire locale. Puis on procède à la lecture et enfin à l'écriture selon ce qui est écrit dans la mémoire locale. Dans une autre variante de réalisation, le signal d'action présynaptique peut comprendre trois impulsions successives qui vont permettre d'assurer une opération de lecture *Read,* une opération d'écriture *Set* et une opération d'écriture *Reset.* Cette variante peut s'avérer avantageuse pour réaliser de telles opérations sur des mémoires bipolaires.

Sur les figures 5, 6 et 7, le circuit 10, 20, 30 comprend un connecteur S_{read} commutable via une commande de lecture Cmd_{read} appliquée par l'unité de contrôle pour connecter l'accumulateur Cm à la borne de propagation B_{P} lorsque l'impulsion de lecture du signal d'action présynaptique est appliquée sur la borne d'activation. Le signal de sortie synaptique qui dépend de la résistance de la mémoire peut ainsi être accumulé.

Ce même connecteur S_{read} est en outre commutable via la commande de lecture Cmd_{read} pour déconnecter l'accumulateur de la borne de propagation lorsque l'impulsion d'écriture du signal d'action présynaptique est appliquée sur la borne d'activation.

Et lorsque cette impulsion d'écriture du signal d'action présynaptique est appliquée sur la borne d'activation, une tension de modification de conductance est imposée à la synapse S1 en venant appliquer un signal d'action postsynaptique sur la borne de propagation. Selon le type d'opération devant être réalisée dans le cadre de l'apprentissage (*Set, Reset* ou non modification de la conductance), on impose sur la ligne de bit BL (au moyen d'un connecteur Sₛₑₜ, Sᵣₑₛₑₜ ou Sₙₒₚₑ commutable via une commande Cmdₛₑₜ, Cmdᵣₑₛₑₜ ou Cmdₙₒₚₑ appliquée par l'unité de contrôle), un signal d'action postsynaptique qui présente l'une des tensions parmi la tension *V_{BLₛₑₜ}* et la tension *V_{BLᵣₑₛₑₜ}* ou un signal neutre qui présente la tension d'alimentation V_{DD}.

Sur la figure 5, on utilise des cellules 1T1R et une tension de ligne de source SL binaire (i.e. variable entre deux niveaux de tension). La tension de la ligne de source SL est positionnée, via la commande de lecture Cmd_{read} de l'unité de contrôle, à la tension de lecture V_{read} lorsque l'impulsion de lecture Iₗ du signal d'action présynaptique Sa1 est appliquée sur la borne d'activation. Elle est positionnée, via une commande d'écriture Cmd_{write} de l'unité de contrôle, à la tension d'alimentation V_{DD} lorsque l'impulsion d'écriture Iₚ du signal d'action présynaptique Sa1 est appliquée sur la borne d'activation. Avec la régulation de la tension de la ligne de bit BL à l'une parmi les tensions *V_{BLᵣₑₛₑₜ}, V_{BLₛₑₜ}* et V_{DD}, la tension aux bornes de la synapse S1 s'établit alors respectivement à la tension de diminution de conductance *Vᵣₑₛₑₜ,* la tension d'augmentation de conductance *Vₛₑₜ* ou à 0 V.

Sur la figure 6, on utilise des cellules 1S1R et le même type de commandes Cmd_{read}, Cmdₛₑₜ, Cmdᵣₑₛₑₜ et Cmdₙₒₚₑ. L'impulsion de lecture du signal d'action présynaptique Sa2 est à la tension de lecture *V_{read}* et l'impulsion d'écriture du signal d'action présynaptique Sa2 est à la tension d'alimentation V_{DD}. Ainsi lorsque l'impulsion de lecture du signal d'action présynaptique Sa2 est appliquée à la borne d'activation, la tension aux bornes de la synapse S1 s'établit à la tension de lecture *V_{read}.* Et lorsque l'impulsion d'écriture du signal d'action présynaptique Sa2 est appliquée à la borne d'activation, la tension de la ligne de bit BL est régulée à l'une parmi les tensions *V_{BLᵣₑₛₑₜ}, V_{BLₛₑₜ}* et V_{DD}, la tension aux bornes de la synapse S1 s'établissant alors respectivement à la tension de diminution de conductance *Vᵣₑₛₑₜ,* la tension d'augmentation de conductance *Vₛₑₜ* ou à 0 V.

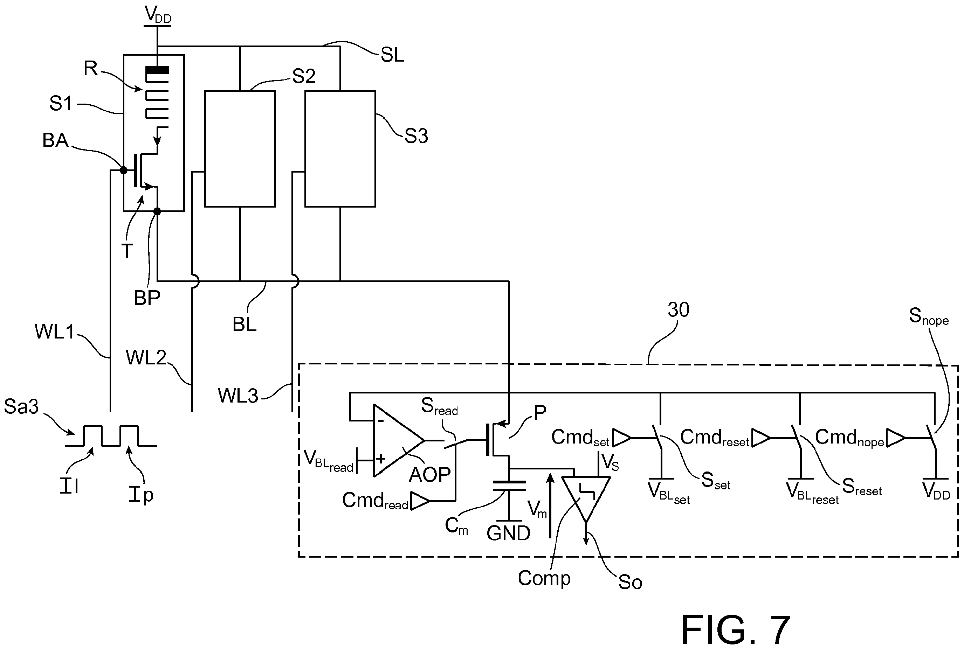

Sur la figure 7, on utilise des cellules 1T1R, le même type de commandes Cmd_{read}, Cmdₛₑₜ, Cmdᵣₑₛₑₜ et Cmdₙₒₚₑ et une tension de ligne de source SL fixe à la tension d'alimentation V_{DD} ce qui permet d'éviter, comparativement à la solution de la figure 5, d'avoir à charger et décharger la ligne de source à chaque impulsion présynaptique. Lorsque l'impulsion de lecture Iₗ du signal d'action présynaptique Sa3 est appliquée sur la borne d'activation, le circuit 30 vient imposer la tension de lecture V_{read} à la synapse en venant appliquer un signal de lecture postsynaptique sur la borne de propagation. Le circuit 30 comporte pour ce faire un amplificateur opérationnel AOP monté en suiveur pour générer le signal de lecture postsynaptique appliqué à la borne de propagation. L'entrée non-inverseuse de l'amplificateur AOP est à une tension *V_{BL_{read}}* telle que *V_{DD}* - *V_{BL_{read}} = V_{read}.* Sa sortie est reliée via le connecteur commutable S_{read} à la grille d'un transistor pmos P dont la source est reliée à la ligne de bit BL et retournée à l'entrée inverseuse de l'amplificateur AOP et dont le drain est relié à l'accumulateur Cm. Ainsi pendant la lecture, il est possible de maintenir un signal de lecture postsynaptique présentant la tension *V_{BL_{read}}* sur la ligne de bit BL tout en intégrant le courant synaptique dans l'accumulateur Cm. L'amplificateur AOP peut être contrôlé, par exemple par la commande Cmd_{read}, de manière à ne pas consommer lors des opérations d'écriture.

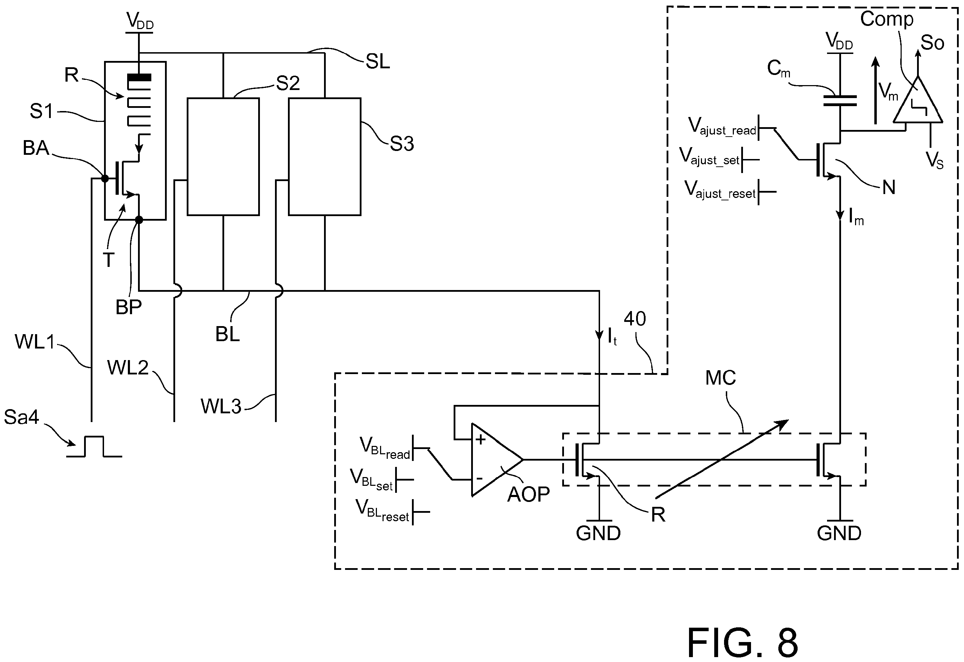

Dans un autre mode de réalisation représenté sur la figure 8, le signal d'action présynaptique Sa4 présente une seule impulsion. Le circuit 40 peut alors réaliser une opération de lecture seule ou bien réaliser simultanément une opération d'écriture et une opération de lecture. Le circuit 40 est pour cela configuré, lorsque le signal d'action présynaptique Sa4 est appliquée sur la borne d'activation, pour imposer une tension de lecture à la synapse en venant appliquer un signal de lecture postsynaptique *V_{BL_{read}}* sur la borne de propagation ou pour imposer une tension d'écriture à la synapse en venant appliquer le signal d'action postsynaptique, à *V_{BLₛₑₜ}* ou *V_{BLᵣₑₛₑₜ},* sur la borne de propagation.

Le circuit 30 comporte un amplificateur opérationnel AOP monté en suiveur pour réguler la tension de la ligne de bit en générant sélectivement le signal de lecture postsynaptique ou le signal d'action postsynaptique. L'entrée inverseuse de l'amplificateur AOP est à l'une des tensions *V_{BL_{red}}, V_{BLₛₑₜ}* ou *V_{BLᵣₑₛₑₜ}.* Sa sortie est reliée à la grille d'un transistor nmos R dont le drain est relié à la ligne de bit BL et retourné à l'entrée non-inverseuse de l'amplificateur AOP et dont la source est reliée à la masse GND.

Le courant It qui traverse la synapse S1 dépend de la valeur de la résistance R ainsi que de la tension sur la ligne de bit. Ce courant dépend donc du type d'opération *Set, Reset* ou *Read.* Afin de pouvoir intégrer le courant synaptique dans l'accumulateur Cm alors même qu'une opération d'écriture est mise en œuvre, le circuit 40 comprend un dispositif abaisseur de courant MC qui est interposé entre la borne de propagation et l'accumulateur Cm et qui est activé lorsque le circuit impose une tension de modification de conductance à la synapse. Comme représenté sur la figure 8, ce dispositif abaisseur de courant MC peut prendre la forme d'un miroir de courant dont on peut faire varier le ratio de transformation de manière à ce que le courant Im parcourant l'accumulateur Cm soit indépendant du type d'accès. Reprenant l'exemple d'une tension d'alimentation *V_{DD}* = 1,8 *V* et des tensions d'accès *Vₛₑₜ* = 1,6 *V, Vᵣₑₛₑₜ* = 1,2 *V* et *V_{read}* = 0,4 *V,* on a donc *Vₛₑₜ* = 4 ∗ *V_{read}* et *Vᵣₑₛₑₜ* = 3 ∗ *V_{read}.* Le dispositif abaisseur de courant est alors configuré pour que Im=It/4 lors d'une opération d'écriture *Set* et pour que Im=It/3 lors d'une opération d'écriture *Reset.*

Dans le circuit de la figure 8, le transistor R utilisé pour la régulation de la tension de la ligne de bit est également exploité dans le miroir de courant MC. Ces deux fonctions peuvent toutefois être dissociées.

Il est par ailleurs possible d'avoir recours à un transistor N entre le dispositif abaisseur de courant MC et l'accumulateur Cm. Différentes polarisations de grille V_{ajust_read}, V_{ajust_set}, V_{ajust_reset} peuvent être sélectivement appliquées à ce transistor N pour venir contrebalancer des différences de polarisation au niveau du dispositif abaisseur de courant MC selon l'accès réalisé et rendre ainsi le courant Im encore plus indépendant du type d'accès.

L'invention n'est pas limitée au circuit précédemment décrit, mais s'étend à une puce neuromorphique comprenant une pluralité de synapses à mémoire résistive agencées en un réseau à lignes et colonnes transversales. Chaque synapse est par exemple du type cellule 1T1R ou cellule 1S1R. Chaque synapse dispose d'une borne d'activation et d'une borne de propagation, les bornes d'activation des synapses d'une même ligne étant reliées entre elles, les bornes de propagation des synapses d'une même colonne étant reliées entre elles et connectées à un circuit d'intégration synaptique tel que décrit précédemment.

## Revendications

1. Circuit d'intégration synaptique (10, 20, 30, 40) pour puce neuromorphique comprenant une synapse à mémoire résistive (S1-S3) qui dispose d'une borne d'activation (B_{A}) pour recevoir un signal d'action présynaptique (Sa1, Sa2, Sa3, Sa4) et d'une borne de propagation (B_{P}) destinée à être reliée audit circuit pour transmettre un signal de sortie synaptique qui dépend de la résistance de ladite mémoire,
ledit circuit comprenant un accumulateur (Cm) du signal de sortie synaptique, un comparateur (Comp) configuré pour émettre une impulsion postsynaptique (So) en cas de franchissement d'un seuil (Vm) par le signal de sortie accumulé, et étant **caractérisé en ce qu'**il comprend une unité de contrôle configurée, lorsqu'un signal d'action présynaptique est appliqué sur la borne d'activation, pour imposer une tension de modification de conductance à la synapse en venant commander l'application d'un signal d'action postsynaptique (*V_{BLₛₑₜ}, V_{BLᵣₑₛₑₜ}*) sur la borne de propagation.

2. Circuit d'intégration synaptique selon la revendication 1, comprenant un connecteur commutable (S_{read}) configuré pour connecter l'accumulateur à la borne de propagation lorsqu'une impulsion de lecture (Iₗ) du signal d'action présynaptique est appliquée sur la borne d'activation.

3. Circuit d'intégration synaptique selon la revendication 2, dans lequel le connecteur commutable est configuré pour déconnecter l'accumulateur de la borne de propagation lorsqu'une impulsion d'écriture (Ip) du signal d'action présynaptique est appliquée sur la borne d'activation.

4. Circuit d'intégration synaptique selon la revendication 2, dans lequel l'unité de contrôle est en outre configurée, lorsque l'impulsion de lecture du signal d'action présynaptique est appliquée sur la borne d'activation, pour imposer une tension de lecture à la synapse en venant commander l'application d'un signal de lecture postsynaptique (*V_{BL_{read}}*) sur la borne de propagation.

5. Circuit d'intégration synaptique selon la revendication 4, comprenant un amplificateur opérationnel (AOP) monté en suiveur pour générer le signal de lecture postsynaptique appliqué à la borne de propagation.

6. Circuit d'intégration synaptique selon la revendication 1, dans lequel l'unité de contrôle est en outre configurée, lorsque le signal d'action présynaptique (Sa4) est appliqué sur la borne d'activation, pour imposer une tension de lecture à la synapse en venant commander l'application d'un signal de lecture postsynaptique (*V_{BL_{read}}*) sur la borne de propagation.

7. Circuit d'intégration synaptique selon la revendication 6, comprenant un amplificateur opérationnel (AOP) monté en suiveur qui est utilisé pour générer sélectivement le signal de lecture postsynaptique ou le signal d'action postsynaptique.

8. Circuit d'intégration synaptique selon l'une des revendications 6 et 7, comprenant un dispositif abaisseur de courant (MC) qui est interposé entre la borne de propagation et l'accumulateur et qui est activé lorsque le circuit impose une tension de modification de conductance à la synapse.

9. Circuit d'intégration synaptique selon l'une des revendications 1 à 8, dans lequel l'unité de contrôle est configurée pour commander l'application du signal d'action postsynaptique sur la borne de propagation conformément à une logique d'apprentissage de type plasticité synaptique pilotée par les impulsions.

10. Circuit d'intégration synaptique selon l'une des revendications 1 à 9, dans lequel le signal d'action postsynaptique est l'un d'un signal de potentialisation et d'un signal de dépression.

11. Puce neuromorphique comprenant une pluralité de synapses à mémoire résistive (S1, S2, S3) agencées en un réseau à lignes et colonnes transversales, chaque synapse disposant d'une borne d'activation (B_{A}) et d'une borne de propagation (B_{P}), les bornes d'activation des synapses d'une même ligne étant reliées entre elles, les bornes de propagation des synapses d'une même colonne étant reliées entre elles et connectées à un circuit d'intégration synaptique (10, 20, 30, 40) selon l'une des revendications 1 à 10.

12. Puce neuromorphique selon la revendication 11, dans lequel chaque synapse à mémoire résistive consiste en une cellule 1T1R ou en une cellule 1S1R.
